(19) **Europäisches Patentamt** / **European Patent Office** / **Office européen des brevets**

(11) **EP 4 760 328 A1**

(12) # EUROPEAN PATENT APPLICATION

(43) Date of publication:
**17.06.2026 Bulletin 2026/25**

(21) Application number: **24219689.7**

(22) Date of filing: **13.12.2024**

(51) International Patent Classification (IPC):
*G01R 33/48* (2006.01)    *G01R 33/561* (2006.01)
*G01R 33/565* (2006.01)    *G01R 33/54* (2006.01)

(52) Cooperative Patent Classification (CPC):
**G01R 33/56509; G01R 33/4818; G01R 33/543; G01R 33/561; G01R 33/5611**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Koninklijke Philips N.V.**
**5656 AE Eindhoven (NL)**

(72) Inventors:
• **MEINEKE, Jan Jakob**
  **Eindhoven (NL)**
• **SOMMER, Karsten**
  **Eindhoven (NL)**

(74) Representative: **Philips Intellectual Property & Standards**
**High Tech Campus 34**
**5656 AE Eindhoven (NL)**

(54) **DYNAMIC MRI SUBSAMPLING ADAPTATION FOR IMPROVED RIGID MOTION COMPENSATION**

(57) Disclosed herein is a method of magnetic resonance imaging, comprising: acquiring intrascan subject motion data; and acquiring k-space data (144) by controlling a magnetic resonance imaging system (102) with pulse sequence commands (142), wherein the pulse sequence commands (142) define an original subsampling pattern (300) and are configured to acquire the k-space data (144) as multiple shots of k-space data; generating an effective subsampling pattern (302) by modifying an original subsampling pattern (300) using a rigid body transformation with the intrascan subject motion data; identifying gaps in the effective subsampling pattern (302) based on a difference between the original subsampling pattern (300) and the effective subsampling pattern (302); generating updated pulse sequence commands (150) configured to acquire gap-located sampling points within the identified gaps in the effective subsampling pattern (302); and acquiring additional k-space data (152) in multiple shots by controlling the magnetic resonance imaging system (102) with the updated pulse sequence commands (150).

300    302

Fig. 3

EP 4 760 328 A1

## Description

### TECHNICAL FIELD

The invention relates to magnetic resonance imaging, in particular to motion-compensation during magnetic resonance imaging.

### BACKGROUND

Magnetic Resonance Imaging (MRI) is essential for high-resolution internal imaging, yet it is highly sensitive to patient motion, which often leads to artifacts and image degradation. Addressing motion-related artifacts, current motion-compensation methods are divided into prospective and retrospective approaches. Prospective methods adjust scan parameters in real-time during data acquisition, often relying on external sensors or MRI-based trackers to detect movement. Retrospective methods correct images post-acquisition, applying motion models to the collected data to minimize the visual impact of movement.

In addition to motion-compensation techniques, MRI subsampling strategies, such as Compressed Sensing and Parallel Imaging, aim to reduce scan times by acquiring only a portion of the data needed to reconstruct high-quality images. However, patient motion during scanning can disrupt the intended sampling patterns, resulting in noise due to unintentional gaps in the data. This misalignment between the ideal and actual sampling patterns challenges the effectiveness of subsampling techniques, leading to a higher noise floor and potential loss in image quality.

Recent advancements have enhanced motion-compensation techniques, yet significant challenges remain, particularly in balancing reduced scan time with artifact-free imaging when motion is present.

### SUMMARY

It is an objective to provide a system, a method and a computer program for motion-compensation during magnetic resonance imaging. The objectives underlying the invention are solved by the features of the independent claims.

In one aspect, a method of magnetic resonance imaging is disclosed. The method comprises: acquiring intrascan subject motion data and k-space data by controlling a magnetic resonance imaging system with pulse sequence commands, wherein the pulse sequence commands define an original subsampling pattern and are configured to acquire the k-space data as multiple shots of k-space data; generating an effective subsampling pattern by modifying an original subsampling pattern using a rigid body transformation with the intrascan subject motion data; identifying gaps in the effective subsampling pattern based on a difference between the original subsampling pattern and the effective subsampling pattern; generating updated pulse sequence commands configured to acquire gap-located sampling points within the identified gaps in the effective subsampling pattern; and acquiring additional k-space data in multiple shots by controlling the magnetic resonance imaging system with the updated pulse sequence commands.

According to an aspect, a medical system comprises a computational system configured to perform any of the disclosed method embodiments.

In an aspect, a further medical system is disclosed. The medical system comprises: a magnetic resonance imaging, MRI, system configured for acquiring k-space data descriptive of a subject at least partially within an imaging zone; a memory storing machine executable instructions and pulse sequence commands configured to acquire the k-space data as multiple shots of k-space data, the pulse sequence commands defining an original subsampling pattern; a subject motion monitor for acquiring intrascan subject motion data; a computational system, wherein execution of the machine executable instructions causes the computational system to: acquire the intrascan subject motion data and the k-space data by controlling the magnetic resonance imaging system with the pulse sequence commands; generate an effective subsampling pattern by modifying the original subsampling pattern using a rigid body transformation with the intrascan subject motion data; identify gaps in the effective subsampling pattern based on a difference between the original subsampling pattern and the effective subsampling pattern; generate updated pulse sequence commands configured to acquire gap-located sampling points within the identified gaps in the effective subsampling pattern; and acquire additional k-space in multiple shots data by controlling the magnetic resonance imaging system with the updated pulse sequence commands.

In another aspect, a computer program comprising machine-executable instructions is disclosed. The machine-executable instructions are configured for causing the computational system to perform the above method.

### BRIEF DESCRIPTION OF THE DRAWINGS

In the following, examples are described in greater detail making reference to the drawings in which:

Fig. 1 illustrates an example of a medical system.
Fig. 2 shows a flow chart which illustrates a method of using a medical system.
Fig. 3 shows an exemplary original subsampling pattern and an exemplary effective subsampling pattern.

### DETAILED DESCRIPTION

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

Disclosed herein are medical systems, methods and computer programs for improved motion-compensation during magnetic resonance imaging. The invention could offer significant advantages by addressing one of the most persistent challenges in MRI: motion artifacts caused by patient movement during scans. By implementing motion compensation, the invention might allow for the real-time adjustment of the subsampling pattern based on intrascan motion data, ensuring that the acquired data may remain consistent and diagnostically useful. Retrospective motion compensation, as e.g., partially described herein, could avoid the risks and complexities associated with prospective techniques, such as requiring hardware modifications, introducing new timing constraints or the failure of motion estimation, which could lead to incorrect updates of the sampling geometry and potentially render the entire scan diagnostically useless. This approach can minimize noise and improve the accuracy of reconstructed images, particularly for patients prone to movement, such as children, elderly individuals, or those with involuntary motion disorders.

The invention can also enhance the efficiency and diagnostic power of MRI by dynamically optimizing the sampling process during the scan. The ability to identify and fill gaps in the effective subsampling pattern can reduce noise amplification and can ensure a better signal-to-noise ratio (SNR), which could directly translate to clearer and more detailed images. Furthermore, the invention can support faster scans by using subsampling techniques while still maintaining image quality, thereby improving patient comfort and potentially increasing scanner throughput in clinical settings. By relying on adjustments informed by real-time motion data, the invention might improve the reliability and flexibility of MRI scans across a wide range of applications and patient populations, offering significant clinical and operational benefits.

In summary, the advantages of these techniques might include significant improvements in image quality through reduced noise and artifacts, enhanced scan efficiency by dynamically adapting the subsampling pattern, and the ability to compensate for motion in real-time without increasing scan duration. Such innovations could allow for the acquisition of more accurate and diagnostically valuable images, even in challenging situations involving patient movement.

Magnetic resonance imaging (MRI) can be described as a medical imaging technique that relies on magnetic fields and radiofrequency pulses to generate detailed images of e.g., tissues and/or organs. It can detect nuclear magnetic resonance signals from hydrogen nuclei in the body, which can then be used to reconstruct high-resolution images of internal structures. The k-space can serve as a mathematical framework in MRI. It can represent the spatial frequencies of the imaging object. The data in k-space can be acquired during the scan and can later undergo a Fourier transform to produce the final image.

Pulse sequence commands define the timing, order, and duration of magnetic field gradients and radiofrequency pulses during MRI data acquisition. These commands can control the sequence of events during the scan, ensuring that k-space data is collected systematically. For example, they divide the acquisition into multiple shots, which could involve splitting the scan into smaller, repeated segments.

Intrascan subject motion refers to subject movement during the MRI scan. Subject movement can distort the acquired data and/or degrade image quality. Such monitoring can enable adaptive compensation for motion effects.

The subsampling pattern can describe the selection of specific k-space data points for acquisition. It may omit other sampling points to accelerate the scanning process. This pattern might be optimized to balance scan speed and image quality, and could be adjusted dynamically to fill gaps caused by motion.

A rigid body transformation might be applied to account for the effects of motion on the acquired data. This transformation can estimate shifts and rotations in the imaging data and might be used to modify the k-space representation accordingly. The system can then generate an effective subsampling pattern that might more accurately reflect the true data acquisition, including the impact of motion.

The intrascan subject motion data may be referenced to the multiple shots of k-space data. Referencing the intrascan subject motion data to k-space shots might involve associating detected motion during the scan with the specific segments of k-space data that are acquired during those moments. This could allow the system to correlate motion artifacts directly with the corresponding k-space shots, enabling targeted corrections. For instance, the system might track motion parameters for each shot, such as rotations or translations, and apply these to adjust the k-space data or subsampling pattern dynamically. This referencing could improve the accuracy of the reconstructed image by ensuring that motion-induced distortions are localized to the exact portions of k-space they affect. For example, if a particular k-space shot is associated with significant patient motion, the system could adapt the subsampling pattern or compensate during reconstruction to mitigate artifacts.

In an example, the system might focus on rigid motion, where subject movement during a scan could be modeled as a combination of translations and rotations without considering deformations of the body. For rigid motion, it might be feasible to apply a rotation to the sampled k-space locations corresponding to a specific motion segment. This approach could allow the system to account for movement directly in the frequency domain, e.g., by rotating the k-space coordinates to align with the motion-compensated frame of reference. Such adjustments might preserve the integrity of the k-space data, enabling accurate reconstruction despite motion during acquisition.

In a different example, the system may additionally also focus on deformable motion, where the subject's anatomy could undergo non-rigid transformations. For deformable motion, simply applying a rotational transformation to k-space may no longer suffice.

In an example, a g-factor is computed. The g-factor, or geometry factor, in MRI might quantify the level of noise amplification introduced by parallel imaging techniques. It may be particularly helpful when using undersampled data. The g-factor can describe how the spatial arrangement of coil sensitivities and the sampling pattern influence the signal-to-noise ratio (SNR) in the reconstructed image. For example, areas with a high g-factor might experience greater noise amplification, e.g., resulting in reduced image quality. The computation of the g-factor might comprise calculating a relationship between sampling patterns, motion artifacts, and image reconstruction. By analyzing the g-factor for the entire motion-affected acquisition, the system could estimate the achievable image quality and guide adjustments to mitigate noise and/or artifacts effectively.

For example, the g-factor is analyzed for rigid motion and/or deformable motion. Analyzing the g-factor could be valuable both for rigid and deformable motion, as it may incorporate coil sensitivities, potentially providing a more comprehensive assessment of the system's potential to e.g., fill k-space gaps compared to a point spread function (PSF) alone. The point spread function might describe how a single point in k-space could be distributed in the reconstructed image, potentially reflecting the spatial resolution and aliasing characteristics of the sampling pattern.

For example, execution of the machine executable instructions further causes the computational system to reconstruct at least one magnetic resonance image from the multiple shots of k-space data and additional k-space data according to a magnetic resonance imaging protocol.

Reconstructing an MRI image might involve transforming the raw k-space data collected during the scan into a visual representation of the subject's anatomy. This process could be accomplished using advanced computational techniques such as Fourier transforms, which may convert frequency and phase information from k-space into spatial domain images. For example, the computational system could combine multiple shots of k-space data with additional gap-filling data to create a final image that minimizes noise and maximizes resolution.

The reconstruction process could also be performed externally, in a cloud-based environment. In such a setup, the raw k-space data might be transmitted securely to a remote server, where powerful computational resources could handle the reconstruction tasks. For example, this approach may enable the use of advanced algorithms and artificial intelligence (AI) techniques that require high-performance computing beyond what is feasible on local hardware. Once reconstructed, the images could be sent back to the local system for review by clinicians.

A magnetic resonance imaging protocol might define the parameters and settings of the scan. The magnetic resonance imaging protocol may comprise pulse sequences, resolution, and sampling patterns.

Performing the reconstruction in a cloud-based environment could offer significant advantages. By transmitting the raw data securely to powerful remote servers, the process might leverage advanced computational resources and algorithms, including AI-based methods, to enhance image quality and reduce artifacts. For instance, cloud computing could allow for faster processing of large datasets and the application of sophisticated techniques not feasible with local hardware.

MRI protocols, which define scan parameters such as pulse sequences and resolution, could further optimize this process by tailoring the reconstruction to the diagnostic needs. A cloud-based setup might support real-time adjustments to these protocols, enabling dynamic refinement of the images during or after the scan.

Cloud reconstruction could also improve scalability and cost-efficiency by reducing the need for high-performance local infrastructure, while offering continuous updates to reconstruction software. Additionally, it might facilitate remote collaboration, allowing specialists to access and analyze images from different locations. For example, in cases of complex anatomy or significant patient motion, the cloud might deliver high-quality images promptly, enhancing diagnostic precision and improving patient outcomes.

For example, execution of the machine executable instructions further causes the computational system to selectively remove sampling points from the effective subsampling pattern, the removing of sampling points comprising: removing sampling points from a region of the effective subsampling pattern when the region has a local sampling point density exceeding a region threshold, the local sampling point density being a measure of distances between sampling points within the region, the region threshold being dependent on a distance from an origin of k-space.

The measure of distances may be an inverse mean Euclidean distance, a Manhattan distance, a Chebyshev distance, a nearest-neighbor distance, and/or a measure derived from kernel density estimation or graph-based methods.

Sampling points in MRI might refer to specific locations in k-space where data is acquired during the scan. These points could represent discrete measurements of spatial frequency and phase information necessary for reconstructing the image. A region in k-space may denote a subset or localized area of the overall k-space. It may be defined by specific boundaries. The inverse mean Euclidean distance might serve as a measure of local sampling point density within a region. This value could be calculated by averaging the distances between each sampling point and its neighbors and then taking the reciprocal of that average. The origin of k-space might refer to the central point in the k-space grid, which could hold the most critical low-frequency information that contributes to image contrast and overall structure.

For example, the removing of sampling points from the region further partially comprises per sampling point within the region: calculating, for the sampling point, a point density metric by calculating the inverse of the mean Euclidean distance to its neighboring sampling points; and consecutively removing sampling points starting from the sampling point with the highest point density metric until the sampling density of the region falls below the region threshold.

For example, the removing of sampling points from the region further partially comprises per sampling point within the region: marking the sampling point as a center for a Gaussian distribution, wherein the width of the Gaussian is based on the local sampling point region threshold; generating a smoothed density map by summing the contributions of all Gaussian distributions across the region; identifying points corresponding to the highest density values in the smoothed map; and consecutively removing sampling points starting from the points with the highest density values until the sampling density of the region falls below the region threshold.

Removing sampling points based on local density within a k-space region could offer significant advantages by improving the effective sampling pattern, particularly in ensuring its incoherence-a critical assumption of compressed sensing techniques. By selectively removing samples in high-density areas, the system could create a more uniform and optimized distribution of sampling points, e.g., preserving critical low-frequency information near the origin of k-space while e.g., enhancing the overall sparsity and randomness of the pattern. This optimization might not only improve the computational feasibility of reconstruction but also minimize noise amplification and artifacts, resulting in clearer, higher-quality images. Additionally, reducing sampling redundancy conserve resources without sacrificing diagnostic accuracy, aligning with the goals of compressed sensing to achieve efficient and effective imaging.

For example, the generation of the effective subsampling pattern is performed during the acquisition of the k-space data.

Generating the effective subsampling pattern during k-space acquisition could enable the system to adapt in real time, in near real time or just once at some point during the scan. This may allow the system to respond to subject motion and maintain uniform sampling density. This capability might reduce motion artifacts and enhance efficiency in clinical workflows. By dynamically optimizing the scan, the system might ensure diagnostic quality in challenging conditions, such as patient motion, while potentially improving patient comfort and reducing the likelihood of repeat scans.

For example, execution of the machine executable instructions further causes the computational system to: receive an acquisition time frame; determine the pulse sequence commands such that acquisition of the k-space data is completed within 50%, in particular within 60%, in particular within 70%, in particular within 80%, in particular within 90% of the acquisition time frame; and determine the updated pulse sequence commands such that acquisition of the additional k-space data is completed within the remaining portion of the acquisition time frame.

This approach could offer significant advantages by ensuring that retrospective motion correction operates entirely within the original scan timeframe, avoiding any prolongation of the procedure. By determining pulse sequence commands to complete the primary k-space data acquisition within a fraction of the allotted time, e.g., 50% to 90% of the total acquisition timeframe, the system might reserve the remaining time for acquiring additional k-space data needed for filling gaps or addressing motion artifacts. This strategy could maintain the diagnostic integrity of the scan while leveraging the remaining time for refinements, ensuring that the retrospective motion correction might seamlessly integrate into the original workflow.

The ability to perform such corrections without extending the scan duration might enhance clinical efficiency, reduce patient discomfort, and support high patient throughput. Additionally, by operating within the predetermined timeframe, the system might prevent disruptions to scheduling and provide reliable, high-quality imaging results without compromising speed or accuracy.

For example, the subject motion monitor is implemented using external sensors, in particular cameras, and/or MRI navigators, in particular orbital navigators and/or image navigators.

MRI navigators might refer to specialized imaging techniques or devices integrated into MRI systems to monitor subject motion during a scan. These navigators could acquire additional data that may allow the system to estimate and compensate for motion in real time. For example, orbital navigators might involve sampling three orthogonal circular trajectories in k-space, which could estimate rigid body motion parameters, such as translations and rotations. Similarly, image navigators might capture reference images at intervals during the scan to detect positional changes.

Cameras, for example Philips VitalEye, might serve as external sensors to monitor subject motion externally. These systems could track patient movement visually and provide additional input for motion correction. However, using external cameras might require additional hardware installation and computational resources to align the motion data with the scanner's coordinate system, ensuring precise integration with the MRI data.

The advantages of these methods might include enhanced accuracy in motion detection, as both internal navigators and external cameras could complement each other to provide robust tracking. For example, MRI navigators might capture motion occurring within the imaging field, while cameras could monitor large-scale body movements. Additionally, integrating such technologies could reduce motion artifacts, improve image quality, and enhance diagnostic reliability without significantly altering the scan protocol. The ability to track and correct motion in real time might also minimize the need for repeat scans, saving time and improving patient comfort.

For example, the identification of the gaps in the effective subsampling pattern at least partially, comprises: performing a binary dilation of the effective subsampling pattern by expanding acquired regions in the effective subsampling pattern; applying a logical XOR, exclusive OR, operation between the dilated sampling pattern and the effective subsampling pattern to identify unacquired regions adjacent to the acquired regions; and identifying the gaps using the identified unacquired regions.

Binary dilation might be described as a mathematical operation used in image processing to expand the boundaries of regions in a binary representation. In the context of an effective subsampling pattern, binary dilation could enlarge the acquired regions in k-space by adding neighboring points to these regions, based on a predefined structure or kernel. For example, if the acquired points are represented as 1s in a binary grid, binary dilation could replace 0s adjacent to these points with 1s, effectively growing the acquired areas outward.

A logical exclusive OR (XOR) operation might refer to a comparison method used to identify differences between two binary patterns. In this scenario, applying an XOR operation between the dilated subsampling pattern and the original effective subsampling pattern could highlight the unacquired regions adjacent to the acquired ones. For example, the XOR might output a 1 only where a point is present in one of the patterns but not in both, isolating the gaps created during binary dilation.

The advantages of these techniques might include the ability to systematically and precisely identify unacquired regions, enabling targeted adjustments to the subsampling pattern. For instance, binary dilation might allow the system to simulate the impact of expanding acquired regions, while the XOR operation could ensure that only the true gaps between acquired and unacquired points are identified. This combination of operations might support real-time optimization of the subsampling pattern, ensuring efficient data acquisition and improved image reconstruction by filling in critical missing points. Additionally, these methods could enhance computational efficiency by focusing processing efforts on specific regions rather than the entire k-space. For example, the identification of the gaps in the effective subsampling pattern at least partially comprises: defining regions in the effective subsampling pattern; calculating a local sampling density of each region by calculating a distance between sampling points within the region; determining relevant regions within the regions where the local sampling density is below a threshold local sampling density; and identifying the gaps using the relevant regions.

The distance may be an inverse mean Euclidean distance, a Manhattan distance, a Chebyshev distance, a nearest-neighbor distance, and/or a measure derived from kernel density estimation or graph-based methods.

This approach could offer significant advantages by enabling a more precise and localized identification of gaps in the effective subsampling pattern. By calculating the local sampling density within defined regions, the system might detect areas of sparse sampling more effectively, focusing on regions that fall below a predefined density threshold. This targeted method could allow the system to prioritize adjustments where they are most needed, ensuring that critical gaps are filled without unnecessarily altering well-sampled regions. Additionally, such a strategy might enhance the efficiency of data acquisition and reconstruction by reducing noise amplification and preserving the uniformity of the sampling pattern, potentially improving image quality and diagnostic reliability while maintaining scan efficiency.

For example, the gap-located sampling points are at least partially chosen by selecting sampling points from the original subsampling pattern that are located within the identified gaps.

Selecting gap-located sampling points directly from the original subsampling pattern might offer significant advantages due to its simplicity and computational efficiency. This method could quickly identify sampling points already pre-determined by the original pattern and check whether they are located within the identified gaps. By relying on the existing sampling design, this approach might avoid the need for complex recalculations or optimization algorithms, allowing for a faster and more straightforward determination of points to fill the gaps.

Such a strategy could integrate seamlessly with real-time MRI acquisition workflows, ensuring that adjustments to the sampling pattern do not disrupt the scan's timeline. Additionally, leveraging the original subsampling pattern might maintain its desirable properties, such as ensuring incoherence and optimal SNR, which are key to compressed sensing techniques. By filling the gaps efficiently, this approach could reduce noise propagation and improve the quality of the reconstructed images, where the SNR improvement is demonstrated. Overall, this method might balance simplicity, speed, and image quality.

For example, the gap-located sampling points are determined per identified gap, the determining per identified gap comprising: determining candidate gap-located sampling points with respective positions within the identified gap; calculating, for the candidate gap-located sampling points, a distance to a nearest existing neighboring sampling point in the effective subsampling pattern; choosing at least one of the candidate gap-located sampling points as the gap-located sampling points consecutively following the order starting with the candidate gap-located sampling point with a greatest distance to a lowest distance.

The distance may be an inverse mean Euclidean distance, a Manhattan distance, a Chebyshev distance, a nearest-neighbor distance, and/or a measure derived from kernel density estimation or graph-based methods.

Euclidean distance might refer to the shortest straight-line distance between two points in a coordinate system, and in the context of k-space in MRI, it could measure how far one sampling point is from another. This measure might be crucial for evaluating the spacing between sampling points in the effective subsampling pattern or identifying gaps. For example, if two points in a 2D k-space have coordinates (xl,yl) and (x2,y2), the Euclidean distance could be calculated using the formula: $d = \sqrt{(x_2 - x_1)^2 + (y_2 - y_1)^2}$ . For example, this concept can be applied to identify gaps in the subsampling pattern by determining candidate sampling points within the gaps and calculating the minimum Euclidean distance from each candidate point to its nearest neighbor in the effective pattern. Points with the largest minimum distances could be selected first to ensure that the added points maximize coverage and uniformity.

In some examples, anisotropic metrics may be employed to account for differences in field-of-view (FOV) or resolution between directions in k-space. Such metrics could reflect the fact that sampling density requirements might vary along different axes, particularly when the FOV or resolution is not uniform. For instance, distances in k-space could be weighted differently along each axis to align with the imaging system's spatial resolution characteristics. Additionally, the design of the sampling pattern could consider the directional capabilities of the parallel imaging coil array. As the sensitivity profiles of the coil elements may differ between directions, the sampling pattern might be adapted to provide denser sampling in directions where parallel imaging efficiency is lower. Incorporating such anisotropic metrics and directional sensitivity considerations could further enhance image quality by optimizing the sampling strategy based on the unique characteristics of the imaging system and the acquisition protocol.

The advantages of the abovementioned gap-filling approach, i.e., of choosing gap-located sampling points, might lie in its ability to dynamically enhance the completeness and uniformity of the sampling pattern in k-space. By iteratively identifying and filling gaps, the system could ensure more comprehensive coverage while maintaining an optimal distribution of sampling points. This process might reduce noise amplification, thereby improving the overall quality of image reconstruction. Additionally, by adapting to the specific characteristics of the imaging system, such as directional variations in resolution or parallel imaging capabilities, the gap-filling strategy could tailor the sampling pattern to the strengths and limitations of the hardware. This approach might enable efficient data acquisition and high-quality imaging without significantly increasing computational complexity, making it a practical solution for real-time adjustments during motion-compensated MRI scans.

For example, the gap-located sampling points are determined per identified gap, the determining per identified gap comprising: determining candidate gap-located sampling points with respective positions within the identified gap; for the candidate gap-located sampling points within the identified gap per candidate gap-located sampling point: adding the candidate gap-located sampling point to the effective subsampling pattern at the respective position to create a modified effective subsampling pattern; calculating a point spread function, PSF, by applying a Fourier transform on the modified effective subsampling pattern; calculating a ratio of a PSF peak value to a standard deviation of the PSF; the determining per identified gap further comprising: choosing at least one of the candidate gap-located sampling points as the gap-located sampling points, consecutively following the order starting with the candidate gap-located sampling point with the highest ratio of PSF peak value to standard deviation to the sampling point with the lowest ratio of PSF peak value to standard deviation.

Calculating the standard deviation of the PSF might comprise choosing a circular region around the center of the PSF, the circular region having an inner width and an outer width, and computing the standard deviation of the PSF values within that circular region.

A point spread function (PSF) might describe how a single point in k-space translates into the spatial domain of an image after reconstruction. It could characterize the spreading or blurring caused by the sampling pattern and reconstruction process, reflecting the system's resolution. For example, in MRI, an ideal sampling pattern might produce a sharp PSF, ensuring accurate localization of image details, while imperfections in the pattern might lead to broader or irregular PSFs, indicating potential image artifacts.

A Fourier transform might serve as the mathematical tool that converts the k-space data into its spatial domain representation. For example, applying a Fourier transform to a modified effective subsampling pattern might generate its corresponding PSF, revealing how the subsampling impacts image clarity and noise distribution.

The PSF peak value might represent the maximum intensity of the PSF, corresponding to the resolution at the location of a sampled point. A higher peak value could indicate better localization of information in the reconstructed image. Conversely, the standard deviation of the PSF might relate to the incoherence of the sampling pattern, with smaller values e.g., suggesting a more uniform and less structured sampling pattern.

For example, determining and/or choosing the gap-located sampling points comprises calculating the effective sampling pattern based on the original subsampling pattern and the subject's motion states, the calculation comprising: dividing the original subsampling pattern into submasks ($P\_t$) corresponding to different motion states (t); applying a transformation ($T(\theta\_t)$) to each submask ($P\_t$) based on motion parameters ($\theta\_t$); and summing the transformed submasks to generate the effective sampling pattern. It may further comprise rounding the effective sampling pattern to a Cartesian grid. It may further comprise applying a non-uniform fast Fourier transform (NUFFT).

For example, determining and/or choosing the gap-located sampling points comprises accounting for the subject's current motion state during the scan, the accounting comprising mapping gap-located sampling points from the effective sampling pattern back to scanner coordinates using a subject's current motion state to determine actual gap-located sampling points. For example, candidate sampling points within a gap might be added to the effective subsampling pattern to create a modified pattern. A Fourier transform could then be applied to calculate the corresponding PSF, and the system might determine the ratio of the PSF peak value to its standard deviation. Candidate points with higher ratios might be prioritized, as they could offer better resolution and lower noise contributions to the image.

The advantages of this approach might include its ability to refine the subsampling pattern dynamically by focusing on points that improve PSF characteristics. This method could ensure that image resolution is optimized while minimizing noise propagation and artifacts. Furthermore, by using real-time calculations of the PSF for different candidate points, the system might adapt efficiently to motion or other changes during the scan, enabling high-quality image reconstruction without extending acquisition time.

For example, in case a distance in between two adjacent gap-located sampling points in a Y plane of the k-space is above a Y threshold, additional one or more gap-located sampling points are added in-between the two adjacent gap-located sampling points in the Y plane until distances between any of the two adjacent gap-located sampling points and any of the one or more additional gap-located sampling points are below the Y threshold.

The Y plane in k-space might refer to a two-dimensional slice of the k-space grid, where one of the axes corresponds to the spatial frequency along the Y direction. In the context of k-space, the Y direction could represent the variation of spatial frequencies. Sampling patterns in k space may be in the kY-kZ plane. Low frequencies near the origin in the Y direction might correspond to broad, smooth variations, while higher frequencies farther from the origin could represent finer details or edges along the vertical axis. Together with other dimensions, such as the Z dimension, the Y direction contributes to encoding spatial information of the image.

For example, when gap-located sampling points are distributed within the Y plane, there might be instances where the distance between two adjacent points exceeds a predefined Y threshold. In such cases, additional sampling points could be added between the two adjacent points to ensure that the spacing falls below this threshold. This process might help maintain uniform sampling coverage and avoid large gaps in the Y direction that could lead to uneven data distribution and image artifacts.

For example, in order to ensure that the timing of sample acquisition within each shot remains consistent with the original MR contrast, an example process could include three specific steps. In Step 1, the system might determine the k-space positions that need to be measured for the remainder of the scan, prioritizing gap-located sampling points that fill gaps while maintaining the desired spatial coverage. Step 2 might involve using a predefined function that describes how k-space is sampled over time. For example, the Y-coordinate could change linearly with time, such that y=0 is sampled at t=1000 ms, or any other values for t, after an inversion pulse, as might be the case in a T1-weighted turbo field echo (TFE) sequence, such as MPRAGE. This function could restrict which Y-coordinates can be sampled at specific times during a shot.

In Step 3, the system might assemble the candidate k-space positions into M shots in a way that ensures the temporal constraints described in Step 2 are satisfied. It might also be necessary to add additional sampling points not initially selected in Step 1 to maintain the timing and spacing requirements within each shot. For example, if the function specifies that certain Y-coordinates must be sampled at precise times to preserve the contrast properties, these coordinates might take precedence, even if they were not identified as gap-located points initially.

The advantages of addressing gaps in the Y plane might include improved uniformity of the sampling pattern, which could enhance the fidelity of image reconstruction. By ensuring that distances between sampling points in the Y direction remain within acceptable limits, the system might reduce noise amplification and improve the overall resolution of the image. Furthermore, dynamically adjusting the sampling pattern in the Y plane could allow the system to adapt to specific scan requirements or subject motion in real time, optimizing image quality without extending the scan duration.

In another example, the conditioning of the inverse problem might also be measured to improve the sampling pattern. While the computation of the point-spread function (PSF) via the Fourier Transform (FT) of the effective sampling pattern could account for the aliasing noise caused by subsampling, this approach might not encompass the full parallel imaging problem, which could require considering the coil sensitivities. To provide a more complete method, the g-factor map, which might represent noise amplification as a function of spatial position, could be computed as follows.

The covariance matrix of the reconstructed image $cov(X)$ might be defined as the expectation value of $XX^H$, where X could contain noise realizations. The image X might be obtained from the measurements Y by inverting the measurement model, such that $X=A^{-1}Y$, where A could represent the full system matrix. This matrix might include $P_t$, which projects onto the measured k-space locations for motion segment t; F, the Fourier Transform; $C_c$, the coil sensitivities; and $T_t$, the motion transform.

From this definition, it might follow that $cov(X) =A^{-1}cov(Y)(A^{-1})^H=A^{-1}\sigma^2(E1^{-1})^H$, assuming uncorrelated Gaussian noise in Y with variance $\sigma^2$. Using algebra and the Moore-Penrose inverse, where $A^{-1}=A^H(A^HA)^{-1}$, the covariance might simplify to $cov(X)=(A^HA)^{-1}\sigma^2$. This expression could be solved efficiently using methods such as Conjugate-Gradient algorithms.

Additionally, other methods to compute the g-factor map might include pseudo-replicas, which could involve simulating noise realizations directly and empirically computing the covariance. These alternative approaches might also extend to nonlinear or regularized problems, offering flexibility depending on the application. Including this more complete, albeit computationally intensive, method might allow for a thorough assessment of the conditioning and improve sampling pattern optimization.

Like numbered elements in these figures are either equivalent elements or perform the same function. Elements which have been discussed previously will not necessarily be discussed in later figures if the function is equivalent.

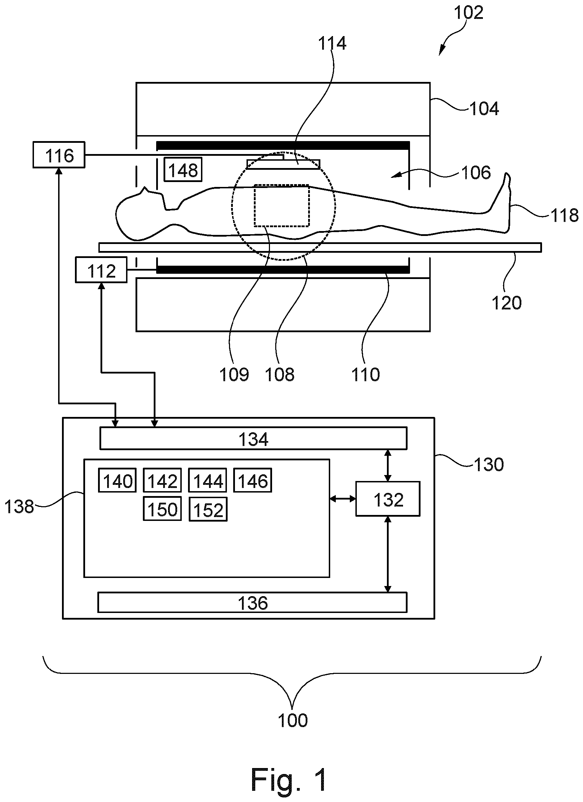

Fig. 1 illustrates an example of a medical system 100 that comprises a magnetic resonance imaging system 102 and a computer 130. The magnetic resonance imaging system 102 comprises a magnet 104. The magnet 104 is e.g., a superconducting cylindrical type magnet with a bore 106 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A field of view 109 is shown within the imaging zone 108. The k-space data is acquired for the field of view 109. The region of interest could be identical with the field of view 109 or it could be a sub volume of the field of view 109. A subject 118 is shown as being supported by an optional subject support 120 such that at least a portion of the subject 118 is within the imaging zone 108 and the field of view 109.

Within the bore 106 of the magnet there is also a set of magnetic field gradient coils 110, which is used for the acquisition of measured k-space data to spatially encode magnetic spins within the imaging zone 108 of the magnet 104. The magnetic field gradient coils 110 are e.g., connected to a magnetic field gradient coil power supply 112. The magnetic field gradient coils 110 are intended to be representative. Typically, magnetic field gradient coils 110 contain three separate sets of coils for spatial encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio frequency coil 114 is connected to a radio frequency transceiver 116. The radio frequency coil 114 and radio frequency transceiver 116 may be replaced by separate transmit and receive coils and a separate transmitter and receiver. It is understood that the radio frequency coil 114 and the radio frequency transceiver 116 are representative. The radio frequency coil 114 is intended to also represent a dedicated transmit antenna and a dedicated receive antenna. Likewise, the transceiver 116 may also represent a separate transmitter and receiver. The radio frequency coil 114 may also have multiple receive/transmit elements and the radio frequency transceiver 116 may have multiple receive/transmit channels. The transceiver 116 and the gradient controller 112 are shown as being connected to a hardware interface 134 of a computational system 132.

The transceiver 116 and the magnetic field gradient coil power supply 112 are shown as being connected to a hardware interface of computer 130. The computer 130 is further shown as comprising the computational system 132. The computer 130 and the computational system 132 may be one or more computer systems or computational systems located at one or more locations. The hardware interface 134 may enable the computational system 132 to communicate with and to control other components of the medical system 100. The computational system 132 is further shown as being in communication with an optional user interface 136 and a memory 138. The memory 138 is intended to represent different types of memory which may be accessible to the computational system 132. The memory is intended to represent any combination of memory or storage device which is accessible to a computational system. The memory may include volatile and non-volatile memory storage means and components. The memory in some embodiments may be based on or may rely on cloud-based data stored in logical pools across disparate, commodity storage servers located on premises or in a data center managed by a third-party cloud provider.

One challenge that might arise in magnetic resonance imaging systems such as the magnetic resonance imaging system 102 may be motion-induced artifacts. For instance, if the subject 118 were to move slightly (e.g., while supported by an optional subject support 120), perhaps adjusting their position or breathing deeply, a resulting magnetic resonance image 146 might appear blurred or distorted. This could be particularly problematic in applications such as imaging the brain or cardiac regions within the imaging zone 108, where precision would be essential. Such artifacts might obscure critical details in acquired k-space data 144, potentially leading to misinterpretation or requiring repeated scans, which could be inefficient and stressful for the subject 118.

To address this, the MRI system 102 could include advanced motion correction modules. For instance, these modules could track patient movement in real-time using external sensors or internal MRI navigators, such as orbital or image navigators. If motion were detected, the system might dynamically adjust imaging parameters or apply sophisticated algorithms to correct for the movement, ensuring that the resulting images remain sharp and clinically useful. Such capabilities would not only improve diagnostic accuracy but could also enhance the patient experience by reducing the likelihood of repeat scans.

Fig. 1 shows one example where the medical system comprises these advanced motion correction modules. In Fig. 1, the medical system 100 further comprises a subject motion monitor 148 for acquiring intrascan subject motion data. In Fig. 1, the subject motion monitor 148 is shown as part of the magnetic resonance imaging system 102. It may, however, be also part of the computing system 130 without the need for an additional module within the magnetic resonance imaging system 102. In that case, the subject motion monitor 148 may receive data from the magnetic resonance imaging system 102 and acquire the intrascan subject motion data based on the data received from the magnetic resonance imaging system 102. The subject motion monitor 148 may also be a completely external module, which may not be part of any of the components depicted in Fig. 1. In the example of Fig. 1, the subject motion monitor 148 is implemented using external sensors, in particular cameras. Alternatively, and/or additionally, it may be implemented using MRI navigators, in particular orbital navigators and/or image navigators.

In order to potentially address the issue of motion-induced artifacts, in a proposed example, the memory 138 would play a crucial role in enabling these advanced functionalities. In Fig. 1, the memory 138 is shown as containing machine-executable instructions 140. The machine-executable instructions 140 enable the computational system 132 to perform such tasks as controlling the magnetic resonance imaging system 102 and performing numerical and image processing tasks. The memory 138 is further shown as containing pulse sequence commands 142.

The computational system 132 executes the machine executable instructions 140. Execution of the machine executable instructions 140 causes the computational system 132 to acquire the intrascan subject motion data and the k-space data by controlling the magnetic resonance imaging system 102 with the pulse sequence commands 142. The pulse sequence commands 142 are configured to acquire the k-space data as multiple shots of k-space data. The pulse sequence commands 142 further define an original subsampling pattern.

The memory 138 is further shown as containing k-space data 144 that was acquired by controlling the magnetic resonance imaging system 102 with the pulse sequence commands 142. The k-space data 144 is divided into different groups or shots of k-space data.

Execution of the machine executable instructions 140 further causes the computational system 132 to generate an effective subsampling pattern by modifying the original subsampling pattern using rigid body transformations with the intrascan subject motion data.

Execution of the machine executable instructions 140 further causes the computational system 132 to identify gaps in the effective subsampling pattern based on a difference between the original subsampling pattern and the effective subsampling pattern.

Execution of the machine executable instructions 140 further causes the computational system 132 to generate updated pulse sequence commands 150 configured to acquire gap-located sampling points within the identified gaps in the effective subsampling pattern. In the example of Fig. 1, the memory 138 is shown to contain the updated pulse sequence commands 150.

Execution of the machine executable instructions 140 further causes the computational system 132 to acquire additional k-space data 152 by controlling the magnetic resonance imaging system 102 with the updated pulse sequence commands 150. In the example of Fig. 1, the memory 138 is further shown as containing the additional k-space data 152 that was acquired by controlling the magnetic resonance imaging system 102 with the updated pulse sequence commands 150. The k-space data 152 is divided into different groups or shots of k-space data.

In the example of Fig. 1, the memory 138 is exemplarily shown as containing a magnetic resonance image 146 that may be reconstructed from the k-space data 144 and the additional k-space data 152, although this example is not necessary to carry out the disclosed invention.

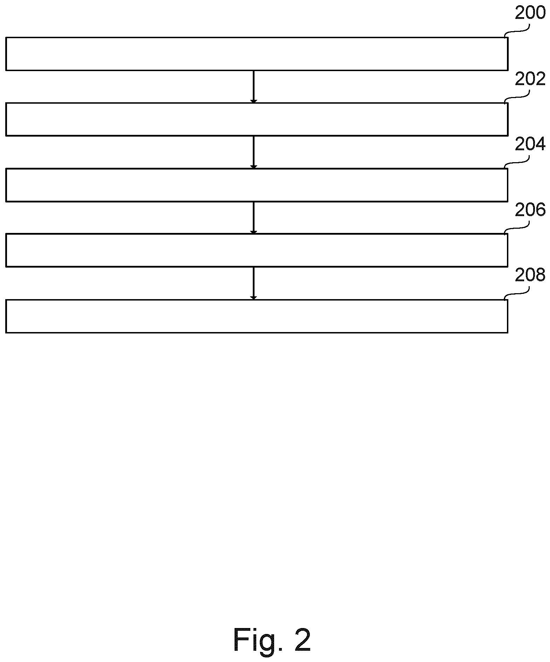

Fig. 2 shows a flowchart which illustrates a method of operating the magnetic resonance imaging system 102 of Fig. 1. In block 200, intrascan subject motion data and k-space data 144 is acquired by controlling a magnetic resonance imaging system 102 with pulse sequence commands 142, wherein the pulse sequence commands 142 define an original subsampling pattern and are configured to acquire the k-space data 144 as multiple shots of k-space data. In block 202, an effective subsampling pattern is generated by modifying an original subsampling pattern using a rigid body transformation with the intrascan subject motion data. In block 204, gaps in the effective subsampling pattern are identified based on a difference between the original subsampling pattern and the effective subsampling pattern. In block 206, updated pulse sequence commands 150 are generated, configured to acquire gap-located sampling points within the identified gaps in the effective subsampling pattern. In block 208, additional k-space data 152 in multiple shots is acquired by controlling the magnetic resonance imaging system 102 with the updated pulse sequence commands 150.

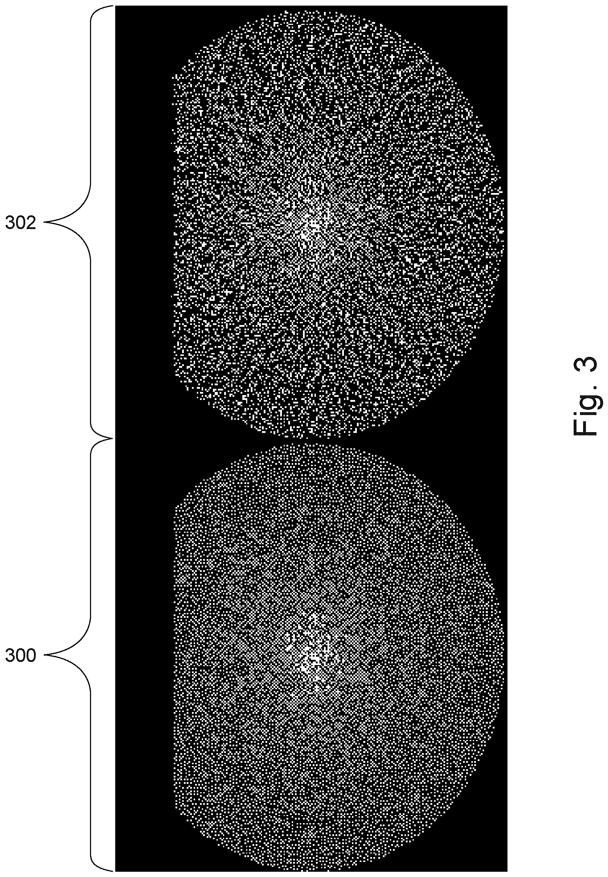

The example of Fig. 3 shows an exemplary original subsampling pattern 300 and an exemplary effective subsampling pattern 302.

It is understood that one or more of the aforementioned aspects and/or examples may be combined as long as the combined aspects and/or examples are not mutually exclusive. In particular, examples of the medical system may be combined with the aspect of the method and/or the aspect of the computer program, as long as the combined aspects and/or examples are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electromagnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Headmounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| | |
|---|---|
| 100 | medical system |
| 102 | magnetic resonance imaging system |
| 104 | magnet |
| 106 | bore of magnet |
| 108 | imaging zone |
| 109 | field of view |
| 110 | magnetic field gradient coils |
| 112 | magnetic field gradient coil power supply |
| 114 | radio frequency coil |
| 116 | transceiver |
| 118 | subject |
| 120 | subject support |
| 130 | computer |
| 132 | computational system |
| 134 | hardware interface |
| 136 | user interface |
| 138 | memory |
| 140 | machine executable instructions |
| 142 | pulse sequence commands |
| 144 | k-space data |
| 146 | magnetic resonance image |
| 148 | subject motion monitor |
| 150 | updated pulse sequence commands |
| 152 | additional k-space data |
| 200 | block: acquiring intrascan subject motion data and k-space data |
| 202 | block: generating an effective subsampling pattern |
| 204 | block: identifying gaps in the effective subsampling pattern |
| 206 | block: generating updated pulse sequence commands |
| 208 | block: acquiring additional k-space data in multiple |
| 300 | original subsampling pattern |
| 302 | effective subsampling pattern |

**Claims**

1. A method of magnetic resonance imaging, comprising:

   - acquiring intrascan subject motion data; and
   - acquiring k-space data (144) by controlling a magnetic resonance imaging system (102) with pulse sequence commands (142), wherein the pulse sequence commands (142) define an original subsampling pattern (300) and are configured to acquire the k-space data (144) as multiple shots of k-space data;
   - generating an effective subsampling pattern (302) by modifying the original subsampling pattern (300) using a rigid body transformation with the intrascan subject motion data;
   - identifying gaps in the effective subsampling pattern (302) based on a difference between the original subsampling pattern (300) and the effective subsampling pattern (302);

- generating updated pulse sequence commands (150) configured to acquire gap-located sampling points within the identified gaps in the effective subsampling pattern (302); and
- acquiring additional k-space data (152) in multiple shots by controlling the magnetic resonance imaging system (102) with the updated pulse sequence commands (150).

2. The method of claim 1, further comprising reconstructing at least one magnetic resonance image (146) from the multiple shots of k-space data (144) and additional k-space data (152) according to a magnetic resonance imaging protocol.

3. The method of any of the preceding claims, further comprising:

   - selectively removing sampling points from the effective subsampling pattern (302), the removing of sampling points comprising:
   - removing sampling points from a region of the effective subsampling pattern (302) when the region has a local sampling point density exceeding a region threshold, the local sampling point density being a measure of distances between sampling points within the region, the region threshold being dependent on a distance from an origin of k-space.

4. The method of any of the preceding claims, wherein the generation of the effective subsampling pattern (302) is performed during the acquisition of the k-space data (144).

5. The method of any of the preceding claims, further comprising:

   - receiving an acquisition time frame;
   - determining the pulse sequence commands (142) such that acquisition of the k-space data (144) is completed within 70%, in particular up to 80%, in particular up to 90% of the acquisition time frame; and
   - determining the updated pulse sequence commands (150) such that acquisition of the additional k-space data (152) is completed within the remaining portion of the acquisition time frame.

6. The method of any of the preceding claims, wherein acquiring intrascan subject motion data is provided by subject motion monitoring (148) implemented using magnetic resonance navigators, in particular orbital navigators and/or image navigators.

7. The method of any of the preceding claims, wherein acquiring intrascan subject motion data is provided by subject motion monitoring (148) implemented using external sensor, in particular camera.

8. The method of any of the preceding claims, wherein the identification of the gaps in the effective subsampling pattern (302) at least partially comprises:

   - performing a binary dilation of the effective subsampling pattern (302) by expanding acquired regions in the effective subsampling pattern (302);
   - applying a logical XOR, exclusive OR, operation between the dilated sampling pattern and the effective subsampling pattern (302) to identify unacquired regions adjacent to the acquired regions;
   - identifying the gaps using the identified unacquired regions.

9. The method of any of the preceding claims, wherein the identification of the gaps in the effective subsampling pattern (302) at least partially comprises:

   - defining regions in the effective subsampling pattern (302);
   - calculating a local sampling density of each region by calculating a distance between sampling points within the region;
   - determining relevant regions within the regions where the local sampling density is below a threshold local sampling density; and
   - identifying the gaps using the relevant regions.

10. The method of any of the preceding claims, wherein the gap-located sampling points are at least partially chosen by selecting sampling points from the original subsampling pattern (300) that are located within the identified gaps.

11. The method of any of the preceding claims, wherein the gap-located sampling points are determined per identified gap, the determining per identified gap comprising:

    - determining candidate gap-located sampling points with respective positions within the identified gap;
    - calculating, for the candidate gap-located sampling points, a distance to a nearest existing neighboring sampling point in the effective subsampling pattern (302);
    - choosing at least one of the candidate gap-located sampling points as the gap-located sampling points consecutively following the order starting with the candidate gap-located sampling point with a greatest distance to a lowest distance.

12. The method of any of the preceding claims, wherein the gap-located sampling points are determined per identified gap, the determining per identified gap comprising:

- determining candidate gap-located sampling points with respective positions within the identified gap;
- for the candidate gap-located sampling points within the identified gap per candidate gap-located sampling point:

- adding the candidate gap-located sampling point to the effective subsampling pattern (302) at the respective position to create a modified effective subsampling pattern;
- calculating a point spread function, PSF, by applying a Fourier transform on the modified effective subsampling pattern;
- calculating a ratio of a PSF peak value to a standard deviation of the PSF;

- choosing at least one of the candidate gap-located sampling points as the gap-located sampling points, consecutively following the order starting with the candidate gap-located sampling point with the highest ratio of PSF peak value to standard deviation to the sampling point with the lowest ratio of PSF peak value to standard deviation.

13. The method of any of the claims 10 to 12, wherein in case a distance in between two adjacent gap-located sampling points in a Y plane of the k-space is above a Y threshold, additional one or more gap-located sampling points are added in-between the two adjacent gap-located sampling points in the Y plane until distances between any of the two adjacent gap-located sampling points and any of the one or more additional gap-located sampling points are below the Y threshold.

14. A medical system for imaging at least a part of a body, comprising a computational system configured to perform a method according to any of the claims 1 to 13.

15. A computer program comprising machine executable instructions, wherein execution of the machine executable instructions causes a computational system to perform a method according to any of the claims 1 to 13.

**Fig. 1**

200

202

204

206

208

# Fig. 2

Fig. 3

Europäisches
Patentamt

European
Patent Office

Office européen
des brevets

# EUROPEAN SEARCH REPORT

Application Number

EP 24 21 9689

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MARXEN M ET AL: "Correcting magnetic resonance k-space data for in-plane motion using an optical position tracking system", MEDICAL PHYSICS, AIP, MELVILLE, NY, US, vol. 36, no. 12, 9 November 2009 (2009-11-09), pages 5580-5585, XP012129831, ISSN: 0094-2405, DOI: 10.1118/1.3254189 * the whole document * | 1-15 | INV.<br>G01R33/48<br>G01R33/561<br>G01R33/565<br>G01R33/54 |
| A | US 2017/332981 A1 (WITSCHEY WALTER R T [US] ET AL) 23 November 2017 (2017-11-23) * the whole document * | 1-15 | |
| A | JULIAN MACLAREN ET AL: "Prospective Motion Correction in Brain Imaging: A Review", ONLINE MAGNETIC RESONANCE IN MEDICINE, , vol. 69, no. 3 1 March 2013 (2013-03-01), pages 621-636, XP002691935, DOI: 10.1002/MRM.24314 Retrieved from the Internet: URL:http://onlinelibrary.wiley.com/doi/10.1002/mrm.24314/pdf [retrieved on 2013-02-11] * the whole document * | 1-15 | |

TECHNICAL FIELDS
SEARCHED (IPC)

G01R

The present search report has been drawn up for all claims

| Place of search | Date of completion of the search | Examiner |
|---|---|---|
| Munich | 30 April 2025 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 9689

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2025

| Patent document cited in search report | Publication date | Patent family member(s) | | Publication date |
|---|---|---|---|---|
| US 2017332981 A1 | 23-11-2017 | US | 2017332981 A1 | 23-11-2017 |
| | | WO | 2016069602 A1 | 06-05-2016 |

EPO FORM P0459

For more details about this annex : see Official Journal of the European Patent Office, No. 12/82